# EUROPÄISCHE PATENTSCHRIFT

(11) **EP 0 792 391 B1**
(45) Veröffentlichungstag und Bekanntmachung des Hinweises auf die Patenterteilung: **01.07.1998**
(21) Anmeldenummer: 95939277.0
(22) Anmeldetag: 14.11.1995
(51) Int. Cl.: C25D 5/08, C25D 17/00, H05K 3/24

(54) **VORRICHTUNG ZUR ELEKTROLYTISCHEN BEHANDLUNG VON PLATTENFÖRMIGEN WERKSTÜCKEN, INSBESONDERE VON LEITERPLATTEN**
ELECTROLYTIC TREATMENT DEVICE FOR PLATE-LIKE WORKPIECES, IN PARTICULAR PRINTED CIRCUIT BOARDS
DISPOSITIF DE TRAITEMENT ELECTROLYTIQUE DE PIECES PLATES, NOTAMMENT DE PLAQUETTES A CIRCUITS IMPRIMES

(30) Priorität: 15.11.1994 DE 4440849
(43) Veröffentlichungstag der Anmeldung: 03.09.1997
(73) Patentinhaber: Siemens S.A., 1060 Bruxelles (BE)
(72) Erfinder: HOSTEN, Daniel, 8610 Handzame (BE)
(74) Vertreter: Epping, Wilhelm, Dr.-Ing.
(86) Internationale Anmeldenummer: EP9504473
(87) Internationale Veröffentlichungsnummer: WO9615294

(56) Entgegenhaltungen:
- GB-A- 2 103 248
- US-A- 4 372 825
- US-A- 4 401 522

## Beschreibung

Aus der EP-A-0 421 127 ist eine Vorrichtung zur Behandlung von Leiterplatten bekannt, bei welcher die einzelnen Leiterplatten in senkrecht hängender Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über an endlos umlaufenden Trieben angeordnete Klammern, die im Falle einer galvanischen Metallabscheidung gleichzeitig auch die kathodische Kontaktierung der Leiterplatten übernehmen. In den Stirnwänden der Behandlungszellen befinden sich vertikale Schlitze für den Durchtritt der Leiterplatten, wobei im Durchtrittsbereich als Bürstendichtungen oder Streifenbürstendichtungen ausgebildete Dichtungen vorgesehen sind. Die einzelnen Behandlungszellen sind in Auffangwannen angeordnet, aus welchen die aufgefangene Badflüssigkeit mit Hilfe entsprechender Pumpen kontinuierlich in die zugeordneten Behandlungszellen zurückgeführt wird. Die Rückführung von Badflüssigkeit in eine Behandlungszelle erfolgt dabei über eine druckseitig an die zugehörige Pumpe angeschlossene Zuleitung, deren Mündung in einer Stirnwand unter dem vertikalen Schlitz für den Durchtritt der Leiterplatten liegt und horizontal in die Behandlungszelle gerichtet ist. Die einströmende Badflüssigkeit soll sich dadurch gleichmäßig auf die beiden Seiten der Leiterplatten verteilen.

Aus der US-A-4 401 522 ist eine ähnlich aufgebaute Vorrichtung zur elektrolytischen Behandlung von Werkstücken, wie z.B. Leiterplatten bekannt, bei welcher den vertikalen Schlitzen in den Stirnwänden der Behandlungszellen als Dichtungen vertikal angeordnete Walzenpaare zugeordnet sind. Die Rückführung von Badflüssigkeit in eine Behandlungszelle erfolgt hier über zwei zu beiden Seiten des Transportweges angeordnete Reihen von vertikal ausgerichteten Sprührohren, die jeweils in Längsrichtung mit einer Reihe von auf die Werkstücke gerichteten Sprühöffnunqen versehen sind. Die Versorgung der Sprührohre erfolgt über eine im Bodenbereich der Behandlungszelle gebildete Verteilkammer, die ihrerseits über die Pumpe mit Badlösung aus der Auffangwanne versorgt wird.

Aus der JP 60-13096 A (in Patents Abstracts of Japan, C-283, Vol 9/No. 125) ist eine Vorrichtung zur elektrolytischen Behandlung von Leiterplatten bekannt, die eine Behandlungszelle zur Aufnahme des Behandlungsbades, zwei im Abstand zueinander in der Behandlungszelle angeordnete, unlösliche Anoden und eine Pumpe zum Umwälzen der Badflüssigkeit umfaßt. Die kathodisch kontaktierten Leiterplatten werden von oben mittig zwischen die beiden Anoden eingehängt, wobei die mit der Pumpe umgewälzte Badflüssigkeit zu beiden Seiten der Leiterplatte von oben her in die Behandlungszelle eingeleitet wird. Zu beiden Seiten der Leiterplatte sind zusätzlich leiterförmige Einbauten mit horizontal verlaufenden Schienen in die Behandlungszelle eingehängt, wobei die Einbauten parallel zur Ebene der Leiterplatte bewegt werden und dadurch die Turbulenz der beidseitig der Leiterplatte von oben nach unten strömenden Badflüssigkeit erhöhen.

Der im Anspruch 1 angegebenen Erfindung liegt das Problem zugrunde, eine Vorrichtung zur elektrolytischen Behandlung von vertikal ausgerichteten plattenförmigen Werkstücken zu schaffen, bei welcher mit einfachen Mitteln eine effektive Beaufschlagung der Werkstücksoberfläche mit Badflüssigkeit und damit ein verbesserter Ionenaustausch im Bereich der durchlaufenden Werkstücke erzielt wird.

Die mit der Erfindung erzielten Vorteile bestehen insbesondere darin, daß die mit einer vertikalen Strömungsrichtung in die Behandlungszelle zurückgeführte Badflüssigkeit mit geringem Aufwand durch in der Behandlungszelle installierte Leitgem Aufwand durch in der Behandlungszelle installierte Leitvorrichtungen auf die Oberfläche der Werkstücke umgeleitet werden kann. Im Vergleich zu der Installation vertikal ausgerichteter Sprührohre in der Behandlungszelle erfordert die Unterbringung von Leitvorrichtungen zu beiden Seiten des Transportweges nur einen geringen Aufwand. Durch den mit der Anströmung der Werkstücke verbesserten Ionenaustausch können die Stromdichten der elektrolytischen Behandlung erheblich gesteigert werden. Bei der ganzflächigen galvanischen Abscheidung von Kupfer auf Leiterplatten, konnten beispielsweise Stromdichten bis zu 10 A/dm² problemlos realisiert werden. Die Leitvorrichtungen dienen dabei gleichzeitig als Führung für die plattenförmigen Werkstücke, so daß andere Maßnahmen zur Führung der Werkstücke durch die Behandlungszellen entfallen können. Durch die Führungseigenschaften der Leitvorrichtungen können insbesondere auch dünne, flexible Leiterplatten im Durchlauf behandelt werden. Außerdem können Werkstücke mit verschiedenen Formaten und Höhen durch die Behandlungszellen geführt werden.

Vorteilhafte Ausgestaltungen der Erfindung sind in den Unteransprüchen angegeben.

Die Weiterbildung nach Anspruch 2 ermöglicht mit geringem Aufwand eine von unten nach oben gerichtete Strömung der Badflüssigkeit zu beiden Seiten des Transportweges. Gemäß Anspruch 3 kann die Rückführung von Badflüssigkeit dabei besonders einfach über eine im Bodenbereich der Behandlungszelle gebildete Verteilkammer vorgenommen werden.

Durch die Ausgestaltung nach Anspruch 4 wird die Verteilung der in die Behandlungszelle zurückgeführten Badflüssigkeit weiter vergleichmäßigt.

Die Weiterbildung nach Anspruch 5 führt zu einer Erhöhung der Turbulenzen der zu beiden Seiten der Werkstücke strömenden Badflüssigkeit.

Die Ausgestaltung nach Anspruch 6 ermöglicht ein alternierendes Anströmen der Werkstücke von beiden Seiten her, so daß im Falle von gelochten Leiterplatten deren Löcher besonders gut durchströmt werden.

Die Weiterbildung nach Anspruch 7 ermöglicht mit besonders geringem Aufwand eine Realisierung der Leitvorrichtungen durch sich in Richtung des Transportweges erstreckende Profile. Durch eine zur Horizontalen geneigte Anordnung dieser Profile, mit einer gemäß Anspruch 8 bevorzugten Neigung von 5 bis 15°, wird eine streifenförmige Abdeckung der Werkstücke durch die Profile verhindert.

Die Ausgestaltung nach Anspruch 9 ermöglicht die Verwendung von handelsüblichen halbrunden Profilen, deren Form auch für die beabsichtigte Umleitung der Badflüssigkeit sehr gut geeignet ist.

Gemäß Anspruch 10 können die Leitvorrichtungen auf besonders einfache Weise an den den Werkstücken zugewandten Seiten der Elektroden angebracht werden. Gemäß den Ansprüchen 11 und 12 können die Leitvorrichtungen im Falle einer galvanischen Metallabscheidung an löslichen oder an unlöslichen Anoden angebracht werden.

Gemäß Anspruch 13 können die Leitvorrichtungen auch an Trägern angebracht werden, die zwischen den Werkstücken und den löslichen Anoden angeordnet sind. Mit dieser Anordnung kann eine weitere Steigerung der Elektrolytbewegung an der Kathode erzielt werden. Außerdem kann durch einen größeren Abstand zwischen Anoden und Kathode eine bessere Schichtdickenverteilung bei großen Aspektverhältnissen erzielt werden. Gemäß Anspruch 14 können die Träger dabei durch poröse Platten gebildet sein. Gemäß Anspruch 15 können die Träger aber auch durch mit durchlässigem Tuch oder Vlies bespannte Rahmen gebildet sein. In beiden Fällen kann im Bereich zwischen den Trägern und den Werkstücken eine äußerst effiziente Elektrolytbewegung realisiert werden.

Ausführungsbeispiele der Erfindung sind in der Zeichnung dargestellt und werden im folgenden näher beschrieben.

Es zeigen
- Figur 1 und Figur 2: in stark vereinfachter schematischer Darstellung eine Vorrichtung zur elektrolytischen Behandlung von plattenförmigen Werkstücken in der Draufsicht bzw. im Querschnitt,
- Figur 3: einen Querschnitt durch eine erste Ausführungsform der Behandlungszelle einer Vorrichtung gemäß den Figuren 1 und 2,
- Figur 4: einen Querschnitt durch eine zweite Ausführungsform der Behandlungszelle einer Vorrichtung gemäß den Figuren 1 und 2 und
- Fgiur 5: einen Querschnitt durch eine dritte Ausführungsform der Behandlungszelle einer Vorrichtung gemäß den Figuren 1 und 2.

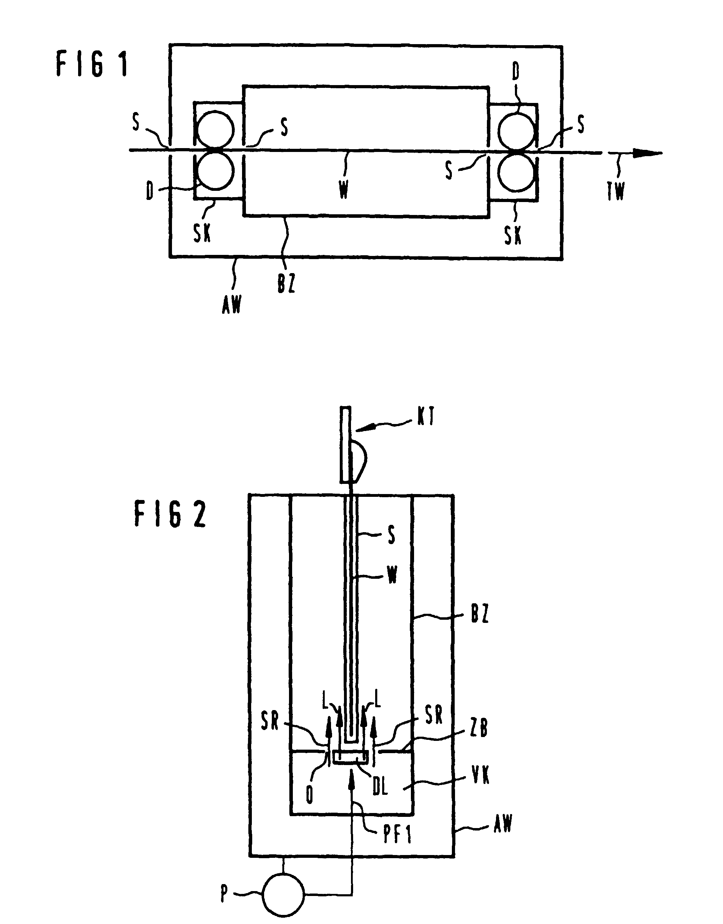

Die Figuren 1 und 2 zeigen in der Draufsicht bzw. im Querschnitt eine in einer Auffangwanne AW angeordnete, ein elektrolytisches Behandlungsbad enthaltende Behandlungszelle BZ, durch welche an Kontaktier- und Transportmitteln KT senkrecht hängende plattenförmige Werkstücke W auf einem horizontalen Transportweg TW hindurchgeführt werden. An den beiden Stirnwänden der Behandlungszelle BZ befinden sich Schleusenkammern SK, in welchen durch kreiszylindrische Kunststoffrohre gebildete Dichtungen D paarweise und in vertikaler Ausrichtung lose angeordnet sind. Die Dichtungen D werden dabei durch den Druck der Badflüssigkeit gegeneinander oder gegen das jeweils durchlaufende Werkstück W gedrückt. Die Stirnwände der Behandlungszellen BZ, der Schleusenkammern SK und der Auffangwanne AW, sind mit vertikalen Schlitzen S versehen, durch welche die plattenförmigen Werkstücke W unbehindert hindurchgeführt werden können. Die aus der Behandlungszelle BZ im Bereich der Schleusenkammern SK austretende und gegebenenfalls auch über die Wände der Behandlungszelle BZ überlaufende Badflüssigkeit wird in der Auffangwanne AW aufgefangen und über eine Pumpe P kontinuierlich in die Behandlungszelle BZ zurückgeführt, so wie es in Figur 2 durch einen Pfeil PF1 angedeutet ist.

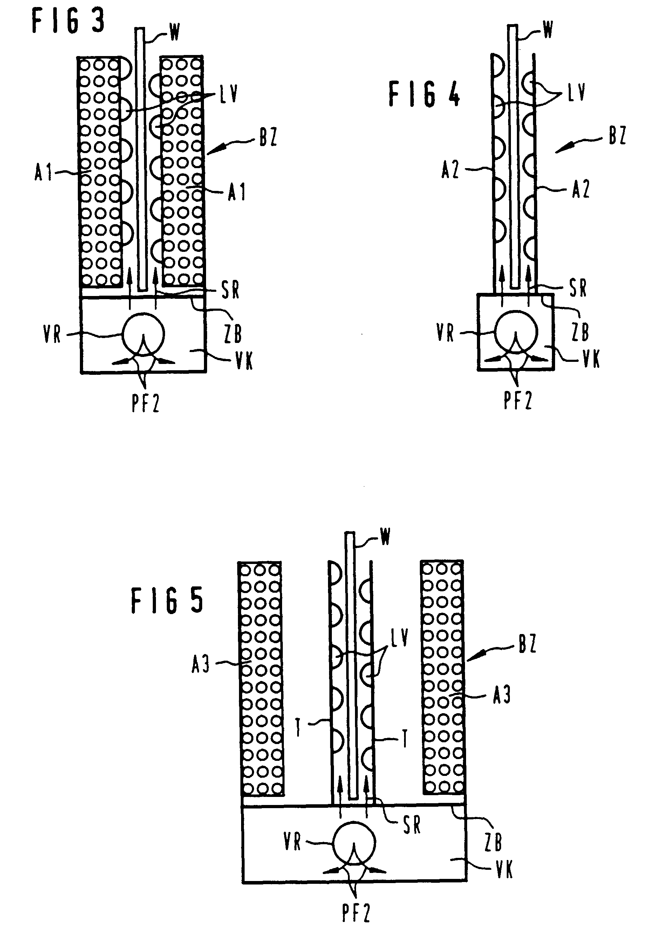

Zu beiden Seiten des Transportweges TW sind in der Behandlungszelle BZ in den Figuren 1 und 2 nicht dargestellte Elektroden angeordnet, welche die entgegengesetzte Polarität der Kontaktier- und Transportmittel KT aufweisen. Im Falle einer galvanischen Metallabscheidung auf die Werkstücke W werden diese über die Kontaktier- und Transportmittel KT kathodisch kontaktiert, während es sich bei den anhand der Figuren 3 bis 5 noch näher zu erläuternden Elektroden um Anoden handelt.

Die bereits erwähnte und in Figur 2 durch den Pfeil PF1 angedeutete Rückführung von Badflüssigkeit in die Behandlungszelle BZ, erfolgt über eine Verteilkammer VK. Diese im Bodenbereich der Behandlungszelle BZ durch einen Zwischenboden ZB gebildete Verteilkammer VK, ist mit zwei Reihen von Öffnungen O versehen, die zu beiden Seiten des Transportweges TW in den Zwischenboden ZB eingebracht sind. Durch diese Öffnungen O strömt dann die von der Pumpe P in die Verteilkammer VK geförderte Badflüssigkeit mit einer vertikalen Strömungsrichtung zu beiden Seiten der Werkstücke W nach oben, so wie es in Figur 2 durch die Pfeile SR angedeutet ist. Die nach oben strömende Badflüssigkeit wird dann durch in den Figuren 1 und 2 nicht dargestellte Leitvorrichtungen zur Oberfläche der Werkstücke W hin umgeleitet. Zur Erhöhung der Turbulenzen der nach oben strömenden Badflüssigkeit wird im Bodenbereich über eine Druckluft-Leitung DL zu beiden Seiten der Werkstücke W Luft in die Behandlungszelle BZ eingeleitet, so wie es in Figur 2 durch Pfeile L angedeutet ist. Verschiedene Möglichkeiten für die Ausgestaltung der Behandlungswannen BZ und für die Anordnung der Leitvorrichtungen in den Behandlungszellen BZ werden im folgenden anhand der Figuren 3 bis 5 näher beschrieben.

Figur 3 zeigt eine erste Ausführungsform einer Behandlungszelle BZ, mit zu beiden Seiten des Transportweges TW (vergleiche Figur 1) der Werkstücke W angeordneten Elektroden, bei welchen es sich um lösliche Anoden A1 handelt. Im Falle einer galvanischen Kupferabscheidung bestehen die löslichen Anoden A1 beispielsweise aus Titankörben und darin untergebrachten Kupferkugeln. Auf den den Werkstücken W zugewandten Seiten der löslichen Anoden A1 sind Leitvorrichtungen LV angebracht, die durch im vertikalen Abstand zueinander angeordnete und zur Horizontalen jeweils um einen Winkel von 10° geneigte, halbkreisförmige Profile gebildet sind. Die beispielsweise auch hochmolekularem PE bestehenden Leitvorrichtung LV, sind in vertikaler Richtung gesehen alternierend zu beiden Seiten der Werkstücke W angeordnet, d.h., jede Leitvorichtung LV einer Seite, befindet sich genau auf halber Höhe zwischen zwei Leitvorrichtungen LV der gegenüberliegenden Seite. Außerdem ist der Abstand zwischen den Leitvorrichtungen LV beider Seiten derart bemessen, daß eine Führung für die durchlaufenden plattenförmigen Werkstücke W gebildet wird.

Im Bodenbereich der Behandlungszelle BZ befindet sich in der durch den Zwischenboden ZB gebildeten Verteilkammer VK ein horizontal ausgerichtetes Verteilrohr VR, welches druckseitig an die Pumpe P (vergleiche Figur 2) angeschlossen ist. Dieses Verteilrohr VR ist auf seiner Unterseite mit im Abstand zueinander angeordneten Löchern versehen, aus welchen die Badflüssigkeit austritt, so wie es in Figur 3 durch die Pfeile PF2 angedeutet ist. Wie bereits im Zusammenhang mit Figur 2 erläutert wurde, strömt die Badflüssigkeit dann mit einer vertikalen Strömungsrichtung SR zu beiden Seiten der durchlaufenden Werkstücke W nach oben in die Behandlungszelle BZ. Die nach oben strömende Badflüssigkeit wird dann durch die Leitvorrichtungen LV wiederholt zur Oberfläche der Werkstücke W hin umgeleitet. Insgesamt entsteht zu beiden Seiten der Werkstücke W jeweils eine mäanderförmige Strömung mit jeweils im Bereich einer Leitvorrichtung LV auf die Oberfläche der Wertkstücke W gerichteten horizontalen Strömungskomponenten. Durch die alternierende Anordnung der Leitvorrichtungen LV werden bei der Behandlung gelochter Leiterplatten deren Durchkontaktierungslöcher sehr gut durchströmt.

Figur 4 zeigt eine zweite Ausführungsform einer Behandlungszelle BZ, bei welcher die Leitvorrichtungen LV an den einander zugewandten Innenseiten von löslichen Anoden A2 angebracht sind. Die beispielsweise aus mit Platin beschichteten Titanplatten bestehenden unlöslichen Anoden A2 bilden gleichzeitig die Seitenwände der Behandlungszelle BZ. Im übrigen stellt sich der anhand der Figur 3 beschriebene Strömungsverlauf der Badflüssigkeit ein.

Figur 5 zeigt eine dritte Ausführungsform einer Behandlungszelle BZ mit zu beiden Seiten des Transportweges TW (vergleiche Figur 1) der Werkstücke W angeordenten Elektroden, bei welchen es sich hier um lösliche Anorden A3 handelt. Zwischen den löslichen Anoden A3 und den durchlaufenden Werkstücken W befinden sich Träger T, an deren einander zugewandten Innenseiten die Leitvorrichtungen LV angebracht sind. Diese Träger T bestehen beispielsweise aus für die Badflüssigkeit durchlässigen porösen Platten oder aus mit durchlässigem PE-Tuch bespannten Titanrahmen. Die sich parallel zu den löslichen Anoden A3 erstreckenden Träger T bilden innerhalb der Behandlungszelle BZ eine Art Innenzelle, in welcher sich der gleiche Strömungsverlauf der Badflüssigkeit, wie bei den Ausführungsformen nach Figur 3 und nach Figur 4 ergibt.

Bei der in Figur 5 dargestellten dritten Ausführungsform muß nur die im Bereich zwischen den Trägern T zurückgeführte Badflüssigkeit mit Hilfe einer relativ kleinen Pumpe über ein Filter geführt werden. In den Bereichen zwischen den Trägern T und den löslichen Anoden A3, kann ein Teil der insgesamt zurückgeführten Badflüssigkeit ungefiltert eingeleitet werden.

## Patentansprüche

1. Vorrichtung zur elektrolytischen Behandlung von plattenförmigen Werkstücken (W), insbesondere von Leiterplatten, mit
- Kontaktier- und Transportmitteln (KT), welche die Werkstücke (W) anodisch oder kathodisch kontaktieren und in vertikaler Lage auf einem horizontalen Transportweg (TW) durch mindestens ein Behandlungsbad führen,
- einer Behandlungszelle (BZ) zur Aufnahme des Behandlungsbades,
- zu beiden Seiten des Transportweges (TW) in den Behandlungszellen (BZ) angeordneten Elektroden mit der entgegengesetzten Polarität der Kontaktier- und Transportmittel (KT),
- vertikalen Schlitzen (S) in den Stirnwänden der Behandlungszelle für den Durchtritt der Werkstücke (W),
- einer Auffangwanne (AW) für die aus der Behandlungszelle (BZ) austretende Badflüssigkeit und mit
- mindestens einer Pumpe (P) zur kontinuierlichen Rückführung von Badflüssigkeit aus der Auffangwanne (AW) in die Behandlungszelle (BZ),
gekennzeichnet durch
- Mittel zur Rückführung von Badflüssigkeit in die Behandlungszelle (BZ) zu beiden Seiten des Transportweges (TW) mit einer zumindest weitgehend vertikalen Strömungsrichtung (SR), und durch
- zu beiden Seiten des Transportweges (TW) in der Behandlungszelle (BZ) angeordnete Leitvorrichtungen (LV), welche Badflüssigkeit zur Oberfläche der Werkstücke (W) hin umleiten, wobei
- die Leitvorrichtungen (LV) derart angeordnet sind, daß sie eine Führung für die Werkstücke (W) bilden.

2. Vorrichtung nach Anspruch 1,
**dadurch gekennzeichnet,**
daß die Rückführung von Badflüssigkeit in die Behandlungszelle (BZ) zumindest teilweise im Bodenbereich der Behandlungszelle (BZ) erfolgt.

3. Vorrichtung nach Anspruch 2,
**dadurch gekennzeichnet,**
daß die Rückführung von Badflüssigkeit in die Behandlungszelle (BZ) über eine in deren Bodenbereich gebildete Verteilkammer (VK) und über zu beiden Seiten des Transportweges (TW) angeordnete Öffnungen (O) der Verteilkammer (VK) erfolgt.

4. Vorrichtung nach Anspruch 3,
**gekennzeichnet durch**
ein sich in der Verteilkammer (VK) in Richtung des Transportweges (TW) erstreckendes und druckseitig an die Pumpe (P) angeschlossenes Verteilrohr (VR) für Badflüssigkeit.

5. Vorrichtung nach einem der Ansprüche 1 bis 4,
**dadurch gekennzeichnet,**
daß im Bodenbereich der Behandlungszelle (BZ) Mittel zur Einleitung von Luft (L) angeordnet sind.

6. Vorrichtung nach einem der Ansprüche 1 bis 5,
**dadurch gekennzeichnet,**
daß die Leitvorrichtungen (LV) in vertikaler Richtung gesehen alternierend zu beiden Seiten des Transportweges (TW) angeordnet sind.

7. Vorrichtung nach einem der Ansprüche 1 bis 6,
**dadurch gekennzeichnet,**
daß die Leitvorrichtungen (LV) durch sich in Richtung des Transportweges (TW) erstreckende und zur Horizontalen geneigte Profile gebildet sind.

8. Vorrichtung nach Anspruch 7,
**dadurch gekennzeichnet,**
daß die Profile zur Horizontalen um 5 bis 15° geneigt sind.

9. Vorrichtung nach Anspruch 7 oder 8,
**dadurch gekennzeichnet,**
daß die Profile einen halbkreisförmigen Querschnitt aufweisen.

10. Vorrichtung nach einem der Ansprüche 1 bis 9,
**dadurch gekennzeichnet,**
daß die Leitvorrichtungen (LV) an den den Werkstücken (W) zugewandten Seiten der Elektroden angebracht sind.

11. Vorrichtung nach Anspruch 10,
**dadurch gekennzeichnet,**
daß die Leitvorrichtungen (LV) an löslichen Anoden (A1) angebracht sind.

12. Vorrichtung nach Anspruch 10,
**dadurch gekennzeichnet,**
daß die Leitvorrichtungen (LV) an unlöslichen Anoden (A1) angebracht sind.

13. Vorrichtung nach einem der Ansprüche 1 bis 9,
**dadurch gekennzeichnet,**
daß die Leitvorrichtungen (LV) an zwischen den Werkstücken (W) und löslichen Anoden (A3) angeordneten Trägern (T) angebracht sind.

14. Vorrichtung nach Anspruch 13,
**dadurch gekennzeichnet,**
daß die Träger (T) durch poröse Platten gebildet sind.

15. Vorrichtung nach Anspruch 13,
**dadurch gekennzeichnet,**
daß die Träger (T) durch mit durchlässigem Tuch oder Vlies bespannte Rahmen gebildet sind.

## Claims

1. Apparatus for electrolytic treatment of workpieces (W) in the form of boards, in particular printed circuit boards,
having
- contact-making and transport means (KT) which make contact with the workpieces (W) anodically or cathodically and carry them in a vertical position on a horizontal transport path (TW) through at least one treatment bath,
- a treatment cell (BZ) for accommodating the treatment bath,
- electrodes arranged on both sides of the transport path (TW) in the treatment cells (BZ), whose polarity is the opposite of that of the contact-making and transport means (KT),
- vertical slots (S) in the end walls of the treatment cell for the workpieces (W) to pass through,
- a catchment trough (AW) for the bath liquid emerging from the treatment cell (BZ), and having
- at least one pump (P) for continuously returning the bath liquid from the catchment trough (AW) to the treatment cell (BZ),
characterized by
- means for returning the bath liquid to the treatment cell (BZ) on both sides of the transport path (TW), with a flow direction (SR) which is at least largely vertical, and by
- guide apparatuses (LV), which are arranged on both sides of the transport path (TW) in the treatment cell (BZ) and guide the bath liquid towards the surface of the workpieces (W),
- the guide apparatuses (LV) being arranged in such a manner that they form a guide for the workpieces (W).

2. Apparatus according to Claim 1, characterized in that the return of the bath liquid to the treatment cell (BZ) takes place at least partially in the base region of the treatment cell (BZ).

3. Apparatus according to Claim 2, characterized in that the return of the bath liquid to the treatment cell (BZ) takes place via a distribution chamber (VK) formed in the base region of the treatment cell (BZ) and via openings (O) in the distribution chamber (VK) which are arranged on both sides of the transport path (TW).

4. Apparatus according to Claim 3, characterized by a distribution tube (VR) for the bath liquid, which extends in the distribution chamber (VK) in the direction of the transport path (TW) and is connected on the pressure side to the pump (P).

5. Apparatus according to one of Claims 1 to 4, characterized in that means for introducing air (L) are arranged in the base region of the treatment cell (BZ).

6. Apparatus according to one of Claims 1 to 5, characterized in that, when viewed in the vertical direction, the guide apparatuses (LV) are arranged alternately on both sides of the transport path (TW).

7. Apparatus according to one of Claims 1 to 6, characterized in that the guide apparatuses (LV) are formed by profiles which extend in the direction of the transport path (TW) and are inclined with respect to the horizontal.

8. Apparatus according to Claim 7, characterized in that the profiles are inclined through 5 to 15° with respect to the horizontal.

9. Apparatus according to Claim 7 or 8, characterized in that the profiles have a semicircular cross-section.

10. Apparatus according to one of Claims 1 to 9, characterized in that the guide apparatuses (LV) are fitted on the sides of the electrodes facing the workpieces (W).

11. Apparatus according to Claim 10, characterized in that the guide apparatuses (LV) are fitted on soluble anodes (A1).

12. Apparatus according to Claim 10, characterized in that the guide apparatuses (LV) are fitted on insoluble anodes (A1).

13. Apparatus according to one of Claims 1 to 9, characterized in that the guide apparatuses (LV) are fitted on supports (T) which are arranged between the workpieces (W) and soluble anodes (A3).

14. Apparatus according to Claim 13, characterized in that the supports (T) are formed by porous plates.

15. Apparatus according to Claim 13, characterized in that the supports (T) are formed by frames which are covered with permeable cloth or felt.

## Revendications

1. Dispositif de traitement électrolytique de pièces plates (W), notamment de plaquettes à circuits imprimés, qui comprend
- des dispositifs de contact et de transport (KT), qui montent les pièces (W) en anode ou en cathode et les font passer en position verticale sur un trajet horizontal (TW) dans au moins un bain de traitement;
- une cellule de traitement (BZ) destinée à recevoir le bain de traitement;
- des électrodes disposées des deux côtés du trajet (TW) dans les cellules de traitement (BZ), et de polarité inverse à celle des dispositifs de contact et de transport (KT);
- des fentes verticales (S) ménagées sur les parois frontales des cellules de traitement et permettant le passage des pièces (W);
- un bac de récupération (AW) pour le liquide du bain sortant de la cellule de traitement (BZ) et
- au moins une pompe (P) pour le retour en continu de liquide du bain du bac de récupération (AW) à la cellule de traitement.
caractérisé par
- des moyens de retour de liquide du bain à la cellule de traitement (BZ) des deux côtés du trajet (TW) selon une direction de courant au moins sensiblement verticale (SR) et par
- des dispositifs de guidage (LV) placés des deux côtés du trajet (TW) dans la cellule de traitement (BZ) et qui dévient du liquide du bain vers la surface des pièces (W),
- les dispositifs de guidage (LV) étant disposés de sorte qu'ils forment un système de guidage pour les pièces (W).

2. Dispositif selon la revendication 1, caractérisé par le fait que le retour de liquide du bain à la cellule de traitement (BZ) se fait, du moins partiellement, dans la région du fond de la cellule de traitement (BZ).

3. Dispositif selon la revendication 2, caractérisé par le fait que le retour de liquide du bain à la cellule de traitement (BZ) se fait par l'intermédiaire d'une chambre de distribution (VK) formée dans la région du fond et par des ouvertures (O) ménagées dans la chambre de distribution (VK) et disposées des deux côtés du trajet (TW).

4. Dispositif selon la revendication 3, caractérisé par un tuyau de distribution (VR) de liquide du bain s'étendant, dans la chambre de distribution (VK), dans la direction du trajet (TW) et raccordé, côté refoulement, à la pompe (P).

5. Dispositif selon l'une quelconque des revendications 1 à 4. caractérisé par le fait qu'il est prévu, dans la région du fond de la cellule de traitement (BZ), des dispositifs d'introduction d'air (L).

6. Dispositif selon l'une quelconque des revendications 1 à 5, caractérisé par le fait que les dispositifs de guidage (LV) sont disposés, verticalement de façon décalée, des deux côtés du trajet (TW).

7. Dispositif selon l'une quelconque des revendications 1 à 6, caractérisé par le fait que les dispositifs de guidage (LV) sont formés de profilés qui s'étendent sur le trajet (TW) et qui sont inclinés par rapport au plan horizontal.

8. Dispositif selon la revendication 7, caractérisé par le fait que les profilés sont inclinés de 5 à 15° par rapport au plan horizontal.

9. Dispositif selon la revendication 7 ou 8, caractérisé par le fait que les profilés ont une section transversale semi-circulaire.

10. Dispositif selon l'une quelconque des revendications 1 à 9. caractérisé par le fait que les dispositifs de guidage (LV) sont fixés sur les côtés des électrodes, qui sont orientés vers les pièces à traiter (W).

11. Dispositif selon la revendication 10, caractérisé par le fait que les dispositifs de guidage (LV) sont fixés sur des anodes solubles (A1).

12. Dispositif selon la revendication 10, caractérisé par le fait que les dispositifs de guidage (LV) sont fixés sur des anodes insolubles (A1).

13. Dispositif selon l'une quelconque des revendications 1 à 9. caractérisé par le fait que les dispositifs de guidage (LV) sont fixés sur des supports (T) disposés entre les pièces à traiter (W) et des anodes solubles (A3).

14. Dispositif selon la revendication 13, caractérisé par le fait que les supports (T) sont formés de plaques poreuses.

15. Dispositif selon la revendication 13, caractérisé par le fait que les supports (T) sont constitués de cadres sur lesquels est tendu un tissu ou un non-tissé perméable.
